# EUROPEAN PATENT APPLICATION

(11) **EP 4 358 120 A1**
(43) Date of publication of application: **24.04.2024**
(21) Application number: 22816034.7
(22) Date of filing: 30.05.2022
(51) Int. Cl.: H01L 21/60

(54) **SEMICONDUCTOR SUBSTRATE ASSEMBLY AND MANUFACTURING METHOD THEREFOR**

(30) Priority: 30.05.2021 JP 2021090724
(71) Applicant: Bondtech Co., Ltd., Minami-ku Kyoto-shi Kyoto 601-8366 (JP); Suga, Tadatomo, Tokyo 164-0003 (JP); Otsuka, Kanji, Higashiyamato-shi, Tokyo 207-0002 (JP)
(72) Inventor: SUGA, Tadatomo, Tokyo 164-0003 (JP); OTSUKA, Kanji, Higashiyamato-shi, Tokyo 207-0002 (JP)
(74) Representative: Michalski Hüttermann & Partner Patentanwälte mbB
(86) International application number: PCT/JP2022/021865
(87) International publication number: WO 2022/255286

(57) **Abstract**

One embodiment of the present disclosure is a joined structure that comprises: a first substrate that has a first joined surface that has a first signal transmission metal region and a first ground metal region insulated from the first signal transmission metal region; and a second substrate that is joined to the first substrate and has a second joined surface that has a second signal transmission metal region and a second ground metal region that is insulated from the second signal transmission metal region. In the joined structure, the first signal transmission metal region and the second signal transmission metal region are joined and the first ground metal region and the second ground metal region are joined.

## Description

The present disclosure relates to a semiconductor substrate joint body and a method for manufacturing the same.

Recently, along with the development of cloud computing, the information processing to handle big data has increased. In particular, artificial intelligence (Al: Artificial Intelligence) processing requires frequent and rapid access to big data. In hardware, the structure of chiplets, 3 D mounting modules, and the like, for example, has evolved. The semiconductor electronic circuit has a multilayer stacked structure in which two or more layers are stacked. Here, electrical connections are formed between wafers-wafers, wafers-chips, and chips-interposers. Alternatively, the semiconductor electronic circuit has a three-dimensional structure, and wafers or chips are stacked. In this way, for example, a memory module is formed, and the access bandwidth of the semiconductor memory can be increased. Alternatively, wafers-wafer-to-wafer bonds have also been employed in power semiconductors.

However, manufacturing processes that include connections between multiple layers in these laminated structures, three-dimensional structures, and the like are cumbersome. Currently, its reliability is a very serious problem. Furthermore, although the demand for high-speed signals is high, a structure that satisfies joint strength and high-speed signal transmission characteristics has not been proposed.

In some embodiments of the present disclosure, a first substrate having a first mating surface with a first signal transmission metal region and a first ground metal region insulated from the first signal transmission metal region; And a second substrate; bonded to the first substrate, the second substrate having a second bonding surface having a second signal transmission metal region and a second ground metal region insulated from the second signal transmission metal region. In some embodiments, the first and second signal transmission metal regions are bonded. In some embodiments, the first and second ground metal regions are bonded.

According to the technology of the present disclosure, for example, a mechanically strong bond or a highly reliable bond can be achieved. Alternatively, for example, high speed signal transmission characteristics in the electronic circuit can be favorably maintained. Furthermore, an electronic circuit, module, or system having such a three-dimensional structure can be constructed.

Further aspects and advantages of the present disclosure will become readily apparent to those skilled in the art from the following detailed description in which only exemplary embodiments of the present disclosure are shown and described. As will be appreciated, the present disclosure is capable of other and different embodiments, some details of which are capable of modifications in various obvious respects without departing from the present disclosure. Accordingly, the drawings and description are to be regarded as illustrative in nature and not restrictive.

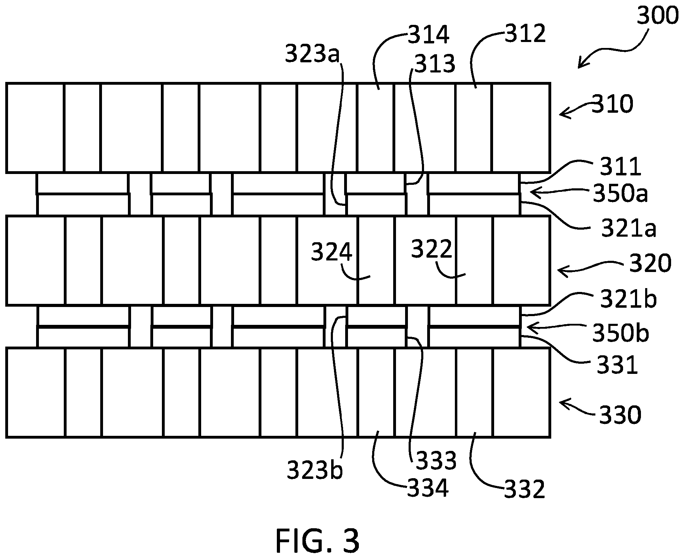

1 A is a cross-sectional view schematically illustrating the structure of a pair of substrates to be bonded in accordance with an embodiment, and; 1 B is a cross-sectional view schematically illustrating the structure of a substrate bonded body manufactured by bonding the pair of substrates. 2 A is a cross-sectional view schematically illustrating the structure of a pair of substrates to be bonded in accordance with an embodiment, and; 2 B is a cross-sectional view schematically illustrating the structure of a substrate bonded body manufactured by bonding the pair of substrates. Is a cross-sectional view illustration schematically illustrating the structure of a substrate bond including three substrates in accordance with an embodiment. Is a cross-sectional view illustration schematically illustrating the structure of a substrate bond including three substrates in accordance with an embodiment. Is a perspective view illustration of a structure of a substrate used in a substrate joint in accordance with an embodiment; Is a top view schematic representation of a configuration of a bonding surface of a substrate in accordance with an embodiment. Is a top view schematic representation of a configuration of a bonding surface of a substrate in accordance with an embodiment. Is a top view schematic representation of a configuration of a bonding surface of a substrate in accordance with an embodiment. Is a top view schematic representation of a configuration of a bonding surface of a substrate in accordance with an embodiment. Fig. 3 is a perspective view illustrating the structure of the substrate joint body used in simulations. Is a graph showing transmission characteristics and reflection characteristics obtained from a simulation.

### < 1. Structures of substrates and bonds >

The term "substrate" as used herein generally refers to a planar material of a semiconductor or insulator. However, the term should not be construed as limiting. A substrate should be interpreted broadly to refer to a structure onto which one or more materials, or layers of one or more materials, may be deposited. The substrate may include one or more layers of material deposited thereon. The substrate can include, for example and without limitation, a wafer or chip that includes one or more layers of material. A dielectric layer, a metal layer, or the like is deposited thereon. The substrate may have a flat plate shape having a substantially constant thickness in the two-dimensional surface direction. However, the shape of the substrate is not limited to a flat plate. The substrate may have a three-dimensional shape.

The substrate may be a chip, wafer, device, module, or the like. The substrate may be a printed circuit board (PCB), interposer, interposer substrate, or the like. The substrate may be a single-sided, double-sided, or multi-layer PCB or interposer. The substrates to be bonded may be of the same type or of substrates belonging to different types or categories. For example, a chip to chip, a wafer to wafer, or a chip to wafer may be bonded. For example, three or more substrates may be bonded. For example, one or more interposer substrates may be bonded to a plurality of semiconductor chips so as to be sandwiched therebetween.

In some embodiments, the substrate has a bonding surface. The bonding surface may be defined as a surface or planar region to be bonded to another substrate. In some embodiments, bonding surface may have a metal region of substantially conductive material. In some embodiments, bonding surface may have a non-metallic region that consists substantially of a non-conductive material. The bonding surface may have a metal region and a non-metal region.

As used herein, a "metal region" refers to a planar region that is generally formed on a surface or bonding surface of a substrate and consists essentially of a conductive material. In some aspects, the metal region may be defined with respect to a dimension normal to the surface of the substrate.

In some embodiments, the surface (top surface) of the metal region may be formed flat. The planar surface of the metal region can be substantially parallel to the bonding surface. In some embodiments, the surface of the metal region can be a curved surface or a contoured surface. The upper surface of the metal region can be configured to be bonded to another substrate. In some aspects, the upper surface of the metal region may be configured to protrude further than the upper surface of the non-metal region provided at the same interface. In some aspects, the upper surface of the metal region may have substantially the same height as the upper surface of the non-metal region provided at the same interface.

The metal region may be connected to a through electrode (sometimes referred to herein as a TSV (through-silicon via), whether the substrate material is primarily Si or not) that penetrates partially or completely within the substrate. The metal region can be connected to an extraction electrode disposed along or through the substrate surface to an end.

As used herein, "metal" generally refers to an electrically conductive material, unless otherwise noted. "Metal" may consist essentially of or include a metallic material, a non-metallic material, or a mixture thereof. The conductive material may be, for example and without limitation, a material that is used or can be used as a semiconductor wiring material. The metal material (hereinafter, also referred to as "metal") may be selected from a group consisting of aluminum (Al), copper (Cu), cobalt (Co), ruthenium (Ru), silver (Ag), and gold (Au), or a group of parts thereof. The metal material may be other metals. The metallic material may be a mixture or alloy of any of a plurality thereof. The conductive material may be a non-metallic conductive material. The conductive material may be of or include, for example and without limitation, carbon (C). Carbon materials include, for example and without limitation, multi-layer graphene (MLG), carbon nanotubes (CNT), and the like.

In some embodiments, the substrate may have a signal transmission metal region and a ground metal region at its interface.

As used herein, the term "signal-transmitting metal region" refers to a metal region used for transmission of signals in a junction. A plurality of signal transmission metal regions may be disposed on the bonding surface. In the joint body, a signal is transmitted through the signal transmission metal region. In some embodiments, the joint may have high speed signal transmission structures in the GHz, THz bands and 10 W to 1000 W compatible capabilities. The joint body may be a connection structure used in an information processing apparatus.

The signal transmission metal region may include at least one signal transmission metal region for transmitting analog signals. The signal transmission metal region may comprise at least one signal transmission metal region for transmitting digital signals. The signal transmission metal regions may comprise at least one analog signal transmission metal region and at least one digital signal transmission metal region at the same interface.

As used herein, the term "ground metal region" refers to a metal region that is connected, for example, to ground and to a power source in a junction and is not intended for signal transmission. In some embodiments, a "ground metal region" may be defined as a metal region other than a signal transmission metal region. A plurality of ground metal regions may be disposed on the bonding face. The ground metal region may be connected to a ground of the joint body. The "ground metal region" may include a narrow ground metal region connected to ground. In some embodiments, the "ground metal region" may include a power supply metal region that is connected to a power supply. The power source provides power to the electronic element within the joint or to which the joint is connected. In some embodiments, the ground metal region may be connected and configured to be connected to any of the ground and the power source at the junction. In some embodiments, the ground metal region may be electrically connected or configured to be connected to a power source. The power supply may be used to drive an electronic element that outputs or receives signals transmitted through the bonded structure. The power source may be electrically connected to the electronic element. The ground metal region may be connected to either polarity of the power supply. The power source may comprise a plurality of power sources. The plurality of power sources may be connected, or configured to be connected, to the plurality of ground metal regions.

In some embodiments, the ground metal region may have a function of thermal conductivity. Such a ground metal region may be referred to as a heat dissipation metal region. The heat dissipation metal region may be connected to a thermal via that penetrates the substrate. This may, for example, conduct heat generated within the device or substrate structure externally or cool them. The thermal vias may be connected to one another across multiple layers or substrates, or may connect heat dissipating metal regions of the multiple layers or substrates. The heat dissipation metal region may be connected to the heat sink via a thermal via or the like. The heat sink may, for example, be disposed in a final layer (top layer or bottom layer) of the substrate structure. In some embodiments, the heat dissipating metal region may be disposed in connection with or within the laminate structure in the power device. The power device may include a heat dissipation metal region.

The ratio (a/A) of the total area (a) of the signal transmission metal region and the ground metal region to the area (A) of the interface on which they are disposed may be greater than or equal to any value of 10,15,20,2_5,30,35,40,45,50,55,60,65,70,75,80,85,90,95%. In some embodiments, this ratio (a/A) may be greater than or equal to 25%. In some embodiments, this ratio (a/A) may be greater than or equal to 30%. In some embodiments, this ratio (a/A) may be greater than or equal to 60%. This ratio may vary from substrate to substrate or from substrate to substrate surface within a single joint body.

In some embodiments, on the same interface, an area of the ground metal region can be greater than an area of the first or second signal transmission metal region.

By bonding the ground metal region having a relatively large area, the bonding strength of the two bonded substrates can be sufficiently increased. For example, sufficient strength can be obtained against thermal stress or application of an external force (such as impact in a drop).

The ground metal region and the signal transmission metal region may be insulated from each other. The ground metal region and the signal transmission metal region may be insulated within the interface. The ground metal region and the signal transmission metal region may be insulated from each other at all times throughout the joint. The ground metal region and the signal transmission metal region may be insulated by an insulating material disposed therebetween. The insulating material may form an insulating surface at the bonding surface. The insulating surface may be configured to be in contact with or bonded to other substrates. The ground metal region and the signal transmission metal region may be disposed in the interface so as to be out of contact or out of contact with each other. The ground metal region and the signal transmission metal region may be insulated from each other by a gas or substantially vacuum.

In some aspects, the ground metal region and the signal transmission metal region may be spaced apart from each other within or in an in-plane direction of the interface. The separation distance in the bonding plane direction may be greater than or equal to any of 0.05 µm, 0.06 µm, 0.07 µm, 0.08 µm, 0.09 µm, 0.1 µm, 0.2 µm, 0.3 µm, 0.4 µm, 0.5 µm, 0.6 µm, 0.7 µm, 0.8 µm, 0.9 µm, 1 µm.

The ground metal region may be disposed so as to surround the signal transmission metal region within the corresponding bonding surface.

In some embodiments, the ground metal region may have metal material formed or arranged substantially solid (gapless) or planar (planar) across the entire region. In other words, the metal region of the ground metal region may be formed substantially solid across the entire region.

In some embodiments, the metal material of the ground metal region may be formed in a portion of the region in area. In some aspects, the ground metal region may have a metal-material-free portion (also referred to as a void, non-metal material portion) in which no metal material is disposed. The metal material or metal material-free portions may be periodically disposed or formed over all or part of the ground metal region. For example, the metal material or metal material-free portions may be arranged or formed in a mesh over all or part of the ground metal region.

The proportion of area occupied by the non-metal material occupied in the ground metal region may be greater than or equal to any of 5%, 10%, 20%, 30%, 40%, 50%, 60%.

The proportion of area occupied by the non-occupied metal material in the ground metal region may be less than or equal to any of 90%, 80%, 70%, 60%, 50%, 40%, 30%, 20%, 10%.

The substrate bonds or bonded structures of the present disclosure may be connected to, configured to be connected to, and include therein various electronic circuits, etc. The electronic circuit may be an optoelectronic circuit (herein, such as "optoelectronic circuit" may also be referred to simply as "electronic circuit", etc.). Electronic circuits include, for example and without limitation, electronic elements, electronic circuit modules, electronic products, electronic systems, and the like. Electronic devices include, for example and without limitation, transistors (MOS, CMOS, FET, CMOS, etc.), op-amp, diode, resistor, inductor, capacitor, photocoupler, transformer, relay, etc. The electronic circuit may include one or both of a digital circuit and an analog circuit.

The electronic circuit may be a digital circuit or element or may be a logic circuit. The electronic circuit may be a logic circuit or may be an integrated circuit (IC) (e.g., a SSI, MSI, LSI, VLSI, ULSI, WSI, SoC, CCD, or CMOS image sensor or the like). The electronic circuit may be an CPU (Central Processing Univt), GPU (Graphic Processing Unit) or the like. The electronic circuit may include, for example and without limitation, a gate circuit such as a AND gate, a OR gate, a NOT gate, a NAND gate, a NOR gate, and a ExOR gate; flip-flop, a counter, a register, a shift register, a latch, an encoder/ Logic function blocks such as decoders, multiplexers/demultiplexers, adders, comparators, and the like; circuits having amplification functions such as buffers, inverters, and the like; switches, multiplexers, oscillators, or phase synchronizing circuits (PLL), and the like.

The electronic circuit may be an analog circuit or element. The electronic circuitry includes, for example and without limitation, an amplifier circuit, an oscillator circuit, a filter circuit, an arithmetic circuit, an impedance matching, a modulator circuit, a power supply circuit, a radio-frequency circuit, etc.

### < Embodiment 1 >

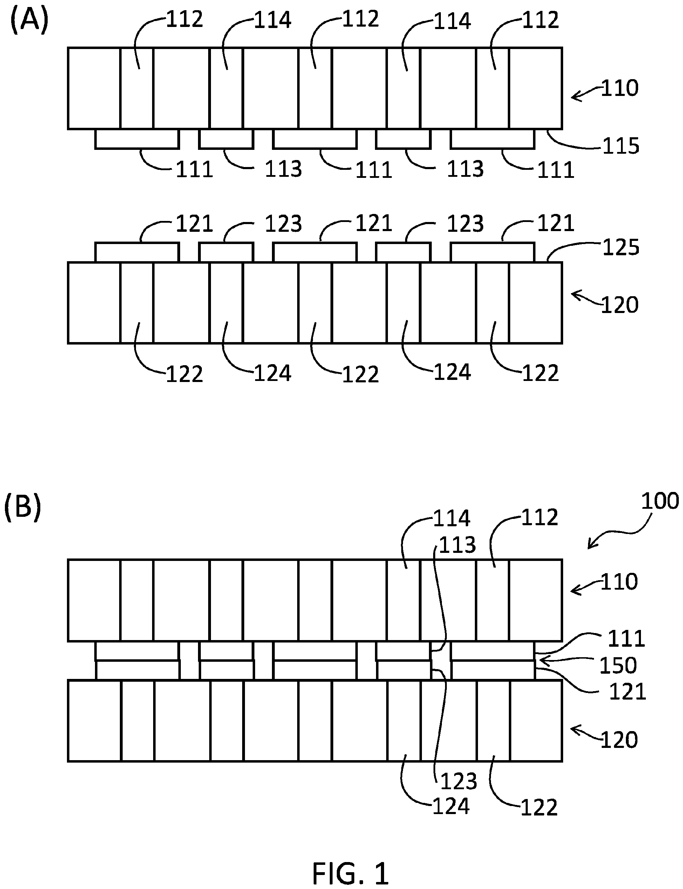

One embodiment will be described with reference to Fig. 1. Fig. 1 A schematically illustrates two substrates 110,120 to be bonded.

The substrate 110 includes a ground metal region 111 and a signal transmission metal region 113 formed on a bonding surface of a substrate main body formed of a semiconductor or an insulator. The substrate 110 is further formed such that a through electrode 112 connected to the ground metal region 111 and a through electrode 114 connected to the signal transmission metal region 113 pass through the substrate 110. The ground metal region 111 and the signal transmission metal region 113 are formed protruding from the surface (insulating surface) 115 of the joining surface of the substrate main body 110. In Fig. 1 A, the ground metal region 111 and the signal transmission metal region 113 are formed so that the surfaces thereof are substantially flush with respect to the insulating surface 115 or the substrate main body 110.

The substrate 120 has the same configuration as the substrate 110. The substrate 120 includes a ground metal region 121 and a signal transmission metal region 123 formed on a bonding surface of a substrate main body formed of a semiconductor or an insulator. The substrate 120 is further formed such that a through electrode 122 connected to the ground metal region 121 and a through electrode 124 connected to the signal transmission metal region 123 pass through the substrate 120. The ground metal region 121 and the signal transmission metal region 123 are formed protruding from the surface (insulating surface) 125 of the joining surface of the substrate main body 120. In Fig. 1 A, the ground metal region 121 and the signal transmission metal region 123 are formed so that the surfaces thereof are substantially flush with respect to the insulating surface 125 or the substrate main body 120.

As illustrated in Fig. 1 B, the ground metal region 111 of the substrate 110 and the ground metal region 121 of the substrate 120 are bonded, and the signal transmission metal region 113 of the substrate 110 and the signal transmission metal region 123 of the substrate 120 are bonded. By this bonding, a bonding interface 150 is formed between the metal regions. As a result, the ground metal region 111 and the through electrode 112 of the substrate 110 and the ground metal region 121 and the through electrode 122 of the substrate 120 were electrically connected. In addition, the substrate 110 and the substrate 120 were bonded to manufacture the substrate bonded body 100. Here, the insulating surface 115 of the substrate 110 and the insulating surface 125 of the substrate 120 do not contact each other or are not bonded. The insulating surface 115 of the substrate 110 and the insulating surface 125 of the substrate 120 may not contact or be bonded to each other in part or in whole.

The present embodiment is not limited to this embodiment, and a high strength bonding interface can be formed by bonding the ground metal region.

### < Embodiment 2 >

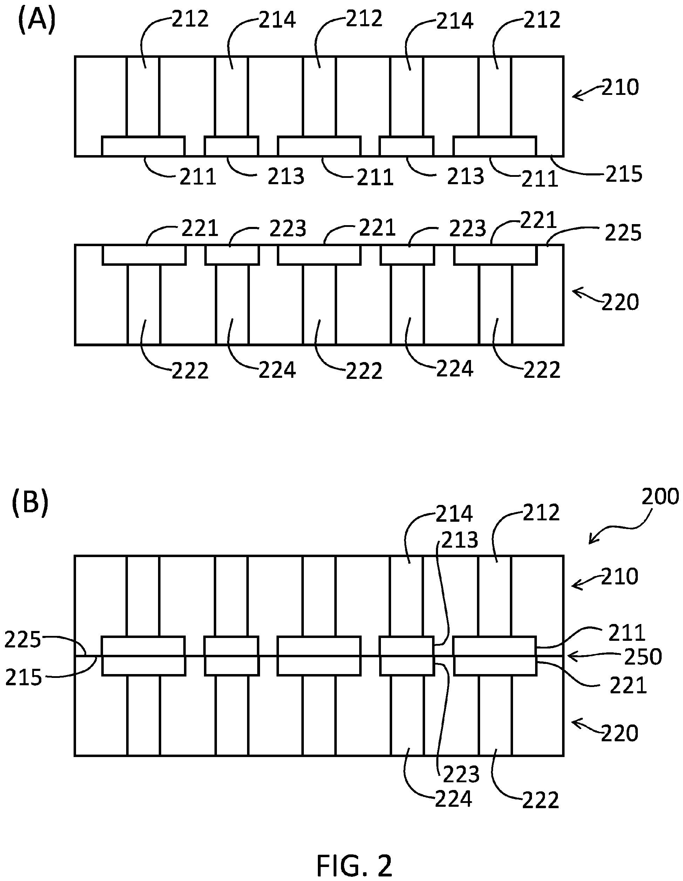

In some embodiments, the insulating surface of the substrate may be configured or bonded to make contact before, during, or after the bonding process. An embodiment will be described with reference to Fig. 2. Fig. 2 A schematically illustrates two substrates 210,220 to be bonded.

The substrate 210 includes a ground metal region 211 and a signal transmission metal region 213 formed on a bonding surface of a substrate main body formed of a semiconductor or an insulator. The substrate 210 of Fig. 2 is further formed so that a through electrode 212 connected to the ground metal region 211 and a through electrode 214 connected to the signal transmission metal region 213 pass through the substrate 210. The ground metal region 211 and the signal transmission metal region 213 are formed so as to be substantially flush with the surface (insulating surface) 215 on the bonding surface of the substrate main body 210. In other words, the surfaces of the ground metal region 211, the signal transmission metal region 213, and the insulating surface 215 have substantially the same height in the substrate 210. The substrate 220 also has the same configuration as the substrate 210.

As illustrated in Fig. 2 B, the ground metal region 211 of the substrate 210 and the ground metal region 221 of the substrate 220 are bonded, the signal transmission metal region 213 of the substrate 210 and the signal transmission metal region 223 of the substrate 220 are bonded, and the insulating surface 215 of the substrate 210 and the insulating surface 225 of the substrate 220 are bonded. By this bonding, a bonding interface 250 is formed between the metal regions. As a result, the ground metal region 211 and the through electrode 212 of the substrate 210 and the ground metal region 221 and the through electrode 222 of the substrate 220 were electrically connected. In addition, the substrate 210 and the substrate 220 were bonded to manufacture the substrate bonded body 200. Here, the insulating surface 215 of the substrate 210 and the insulating surface 225 of the substrate 220 are in contact with or bonded to each other. The insulating surface 215 of the substrate 210 and the insulating surface 225 of the substrate 220 are partially or wholly in contact with each other or bonded.

The present invention is not limited to this embodiment, and bonding the insulating surfaces makes it possible to form a bonding interface with a higher strength.

In some embodiments, even if the metal region protrudes relative to the insulating surface as in Fig. 1, bonding of the insulating surface may occur. For example, the metal region may first contact the other substrate, and then or simultaneously, the insulating surface may contact the other substrate due to elastic or plastic deformation of the substrate. Such a phenomenon is likely to occur when the surface of the insulating surface has high cohesive strength (e.g., is activated).

In some embodiments, the metal region may be formed in a concave shape with respect to the insulating surface (not shown). In other words, the metal region may be formed lower than the insulating surface. In this case, the insulating surface contacts another substrate. However, subsequent expansion due to heating may cause the metal region to contact the other substrate. Alternatively, heating may cause atoms in the metal region to diffuse and reach other substrates.

### < Embodiment 3: Multilayer construction 1 >

In some embodiments, three or more substrates may be bonded. An embodiment will be described with reference to Fig. 3. A substrate joint body 300 illustrated in Fig. 3 includes an upper substrate 310, a lower substrate 330, and an intermediate substrate 320 sandwiched therebetween. Here, as illustrated in the first embodiment, the metal region of each substrate protrudes from the insulating surface at each joining surface. The intermediate substrate 320 can be, for example and without limitation, an interposer substrate.

A ground metal region 321 a and a signal transmission metal region 323 a are disposed on the top surface of the intermediate substrate 320, and are bonded to the ground substrate region 311 and the signal transmission metal region 313 of the top substrate 310, respectively. A ground metal region 321 b and a signal transmission metal region 323 b are disposed on the bottom surface of the intermediate substrate 320, and are bonded to the ground substrate region 331 and the signal transmission metal region 333 of the lower substrate 330, respectively. By this bonding, a bonding interface 350 a, 350 b is formed between the metal regions. As a result, the ground metal region 311 and the through electrode 312 of the upper substrate 310, the ground metal region 321 a, the through electrode 322, and the ground metal region 321 b of the intermediate substrate 320, and the ground metal region 331 and the through electrode 332 of the lower substrate 330 are electrically connected. Furthermore, the signal transmission metal region 313 and the through electrode 314 of the upper substrate 310, the signal transmission metal region 323 a and the through electrode 324 and the through electrode 323 b of the intermediate substrate 320, and the signal transmission metal region 333 and the through electrode 334 of the lower substrate 330 are electrically connected. The upper substrate 310, the intermediate substrate 320, and the lower substrate 330 are bonded to form a substrate bonded body 300.

### < Embodiment 4: Multilayered structure 2 >

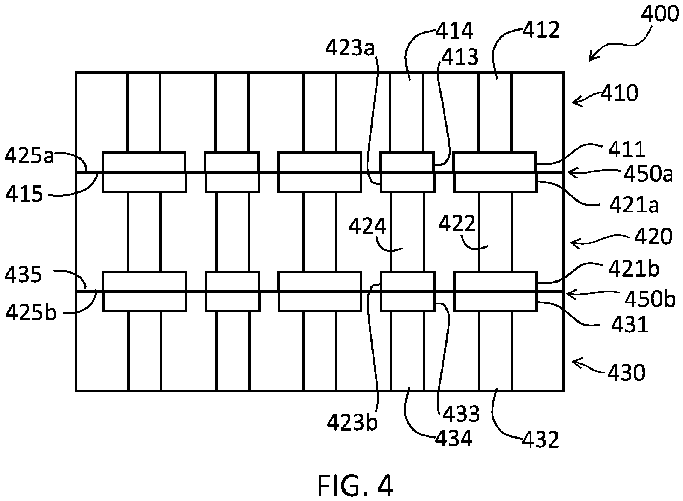

One embodiment will be described with reference to Fig. 4. A substrate joint body 400 illustrated in Fig. 4 includes an upper substrate 410, a lower substrate 430, and an intermediate substrate 420 sandwiched therebetween. Here, as illustrated in the second embodiment, in each substrate, the metal region is formed substantially flush with the insulating surface at each joining surface. Similar to embodiment 3, the intermediate substrate 420 can be, for example and without limitation, an interposer substrate.

The ground metal region 421 a, the signal transmission metal region 423 a, and the insulating surface 425 a are disposed on the top surface of the intermediate substrate 420, and are bonded to the ground substrate region 411, the signal transmission metal region 413, and the insulating surface 415 of the top substrate 410, respectively. The ground metal region 421 b, the signal transmission metal region 423 b, and the insulating surface 425 b are disposed on the bottom surface of the intermediate substrate 420, and are bonded to the ground substrate region 431, the signal transmission metal region 433, and the insulating surface 435 of the lower substrate 430, respectively. By this bonding, a bonding interface 450 a, 450 b is formed between the metal regions. As a result, the ground metal region 411 and the through electrode 412 of the upper substrate 410, the ground metal region 421 a, the through electrode 422, and the ground metal region 421 b of the intermediate substrate 420, and the ground metal region 431 and the through electrode 432 of the lower substrate 430 are electrically connected. Furthermore, the signal transmission metal region 413 and the through electrode 414 of the upper substrate 410, the signal transmission metal region 423 a and the through electrode 424 and the through electrode 423 b of the intermediate substrate 420, and the signal transmission metal region 433 and the through electrode 434 of the lower substrate 430 are electrically connected. Furthermore, the insulating surface is bonded to another insulating surface. The upper substrate 410, the intermediate substrate 420, and the lower substrate 430 are bonded to form a substrate bonded body 400.

### < Example 1: Structure of Substrate >

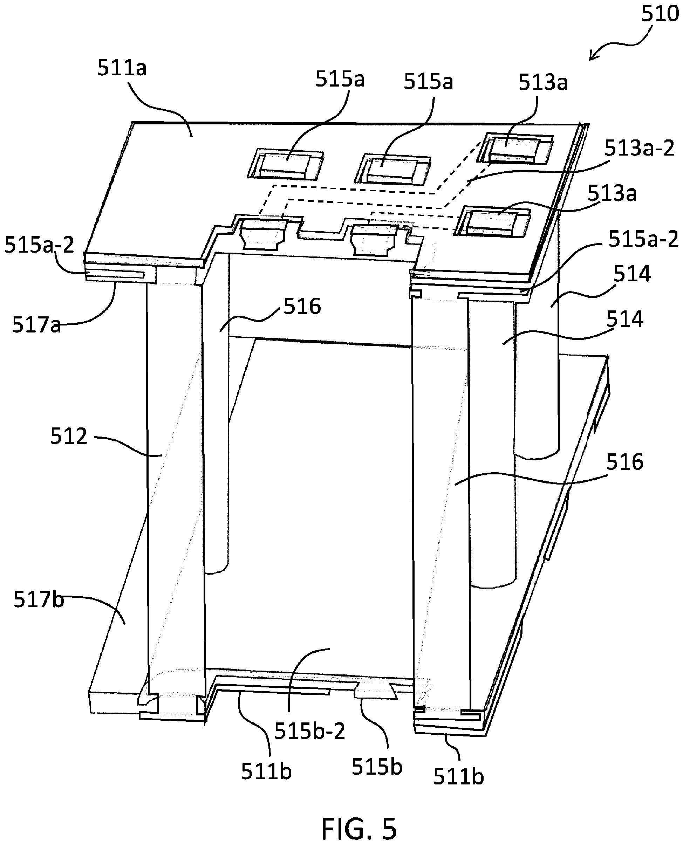

Fig. 5 shows the structure of substrate 510, which can be used as an interposer, as a non-limiting example. Fig. 5 is a perspective view of substrate 510 with insulator or semiconductor portions in the center thereof omitted to show internal structure.

The substrate 510 illustrated in Fig. 5 is provided with a ground metal region 511 a, a signal transmission metal region 513 a, and a power supply metal region 515 a on the top surface thereof, and is configured to be bonded to that region of the substrate to be bonded from the top surface. Furthermore, the power supply plane 515 a-2 is disposed in the second layer from the top, and is connected to the power supply metal region 515 a on the top surface. The interconnection 513 a-2 that connects the plurality of signal transmission metal regions 513 a is disposed on the two-layer surface from the top. They are insulated from each other by an organic insulator 517 a. The ground metal region 511 a is connected to a corresponding through electrode 512. The signal transmission metal region 513 a is connected to the corresponding through electrode 514. The power supply metal region 515 a is connected to the power supply plane 515 a-2 and the corresponding through electrode 516.

The substrate 510 illustrated in Fig. 5 further includes a ground metal region 511 b, a signal transmission metal region 513 b (not illustrated), and a power supply metal region 515 b on the bottom surface thereof, and is configured to be bonded to the corresponding region of the substrate to be bonded from the bottom surface. The power supply plane 515 b-2 is disposed in the second layer from the bottom, and is connected to the power supply metal region 515 b on the bottom surface. They are insulated from each other by an organic insulator 517 b. The ground metal region 511 b is connected to a corresponding through electrode 512. The signal transmission metal region 513 b (not illustrated) is connected to the corresponding through electrode 514. The power supply metal region 515 b is connected to the corresponding through electrode 516.

The interface may comprise a digital signal transmission region and an analog signal transmission region, or may comprise one of them.

### < Embodiment 3: Configuration of Bonding Surface 1 >

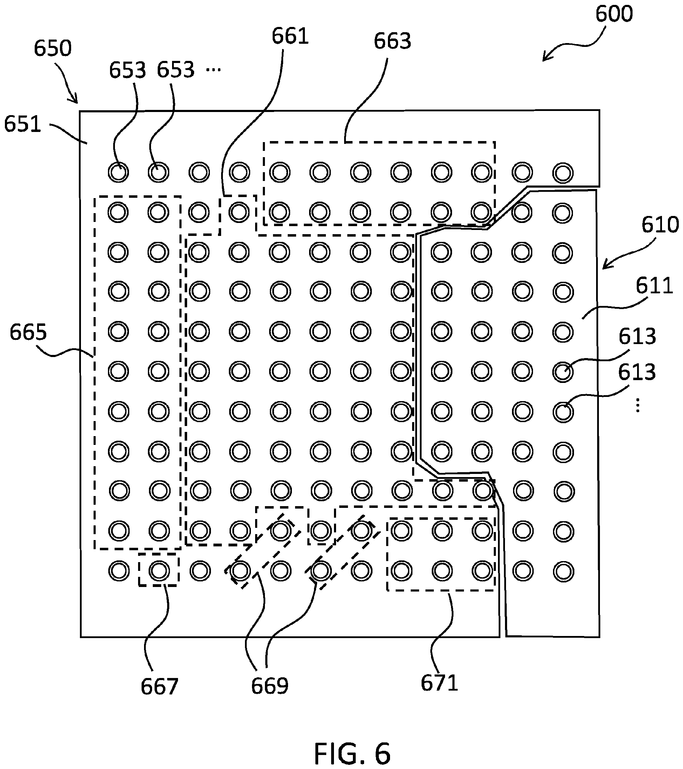

Fig. 6 illustrates a configuration of a bonding surface 600 including an analog signal transmission region 610 and a digital signal transmission region 650, as an embodiment. Fig. 6 can be used, for example and without limitation, for either interposer and PCB.

As illustrated in Fig. 6, the bonding surface 600 includes an analog signal region 610 and a digital signal region 650.

The analog signal region 610 includes an analog ground metal region 611 and an analog signal transmission metal region 613. A plurality of analog signal transmission metal regions (or pads) 613 are arranged. The analog ground metal region 611 is spaced apart from and is disposed surrounding the analog signal transmission metal region 613. The analog ground metal region 611 is coupled to a ground (not illustrated). The analog signal transmission region 613 may be connected, or configured to be connected, to an analog element. Analog signal transmission region 613 may correspond to various pins, including, for example and without limitation, the following: gate voltage (LNA_ VDD) of low noise amplifier (LNA), ground (LNA_ GND); Gate voltage (RI_ VDD) of IN (LNA_ IN) and NIN (LNA_ NIN); ring indicator (RI) and ground (RI_{_} GND); gate voltage (TX_{_} VDD) of transmission circuit (TX); Ground (TX_{_} GND), differential pair of outputs OUT (TX_ OUT) and Vdd (SW_ VDD) of NOUT (TX_{_} NOUT); switch (SW), ground (SW_ GND), Differential pair of controls (SW_ CTL, NSW_ CTL); test refresh (RF) signal (RF_ TST); test ground (TEST_ GND); clock signal (TCLK_ IN);, etc. The types of analog signal transmission regions 613 shown in Fig. 6 and above are illustratively shown, and these groups should not be construed as limiting.

The digital signal region 650 includes a digital ground metal region 651 and a digital signal transmission metal region 653. A plurality of digital signal transmission metal regions (or pads) 653 are arranged. The digital ground metal region 651 is spaced apart from and is disposed surrounding the digital signal transmission metal region 653. The digital ground metal region 651 is connected to a ground (not illustrated). The digital signal transmission region 653 may be connected or configured to be connected to a digital element. The digital signal transmission region 613 may correspond to various pins. Depending on the type of signal to be transmitted, the signal is classified as follows. However, they include, for example and without limitation: digital device (D) signal transmission region 661: digital device gate voltage (D_ VDD) and ground (D_ GND); control signal transmission region 663: (REQ (Request to Send); AQ (Acquire to Send), ENABLE (Enable for signal)); High speed bus signal transmission region 665: (Q/NQ (Output Signal/Negative output signal); D/ND (Input Signal/Negative input signal)); signal transmission region to adjacent ball-lid array 667; clock signal transmission region 669 (data clock (DCLK), Timing circuits (TADJ), TX_ VALID (Transmit Signal Valid), DPH (Data Phase timing), and the like)); serial communication signal transmission region 671 (TXD/NTXD);, and the like. However, the groupings and types of digital signal transmission regions 652 shown in Fig. 6 are illustratively shown, and these groupings should not be construed as limiting.

### < Example 4: Configuration of Bonding Surface 2 >

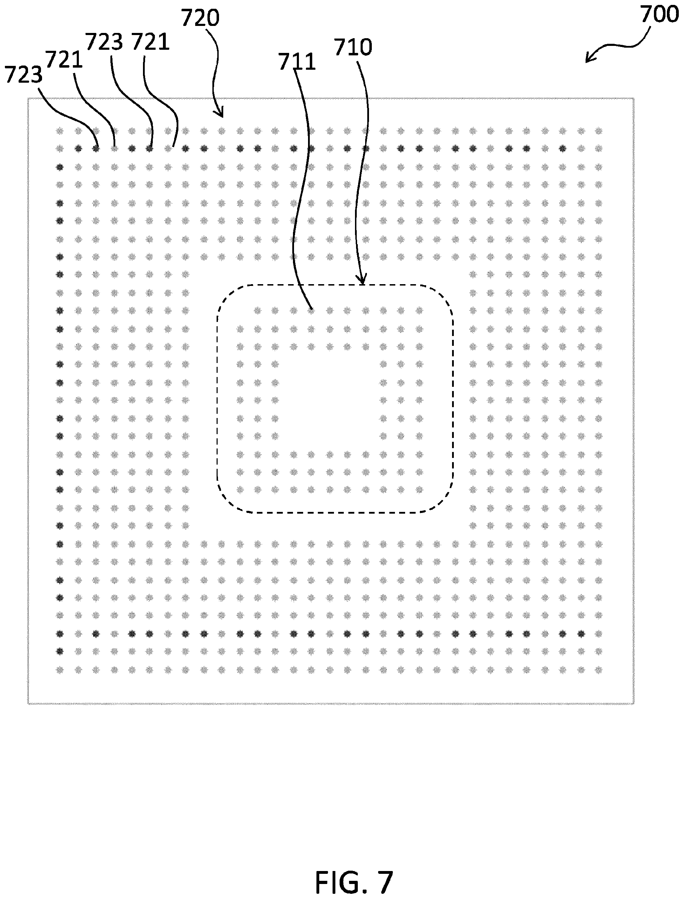

Fig. 7 illustrates a configuration of a bonding surface 700 including a ground metal region 710 and a signal transmission metal region 720 according to an example. Fig. 7 can be used, for example and without limitation, for either interposer and PCB, for example and on one side of a single-ended pad.

The ground metal region 710 illustrated in Fig. 7 is defined in a center portion of the bonding surface 700. The substantial metal portion 711 of the ground metal region 710 is not formed singularly, continuously or solidly, but is formed individually as pins 711. The pins 711 of the ground metal region 710 are connected, or configured to be connected, to a power supply or ground.

The signal transmission metal region 720 illustrated in Fig. 7 is defined around and surrounding the ground metal region 710. A substantial metal portion of the signal transmission metal region 720 is formed in a pin shape. The pins of the ground metal region 710 include a signal metal region 721 and a ground metal region 723. They are connected or configured to be connected to the gate voltage (VDD) or ground (GND) of the device, respectively.

### < Embodiment 5: Configuration of Bonding Surface 4 >

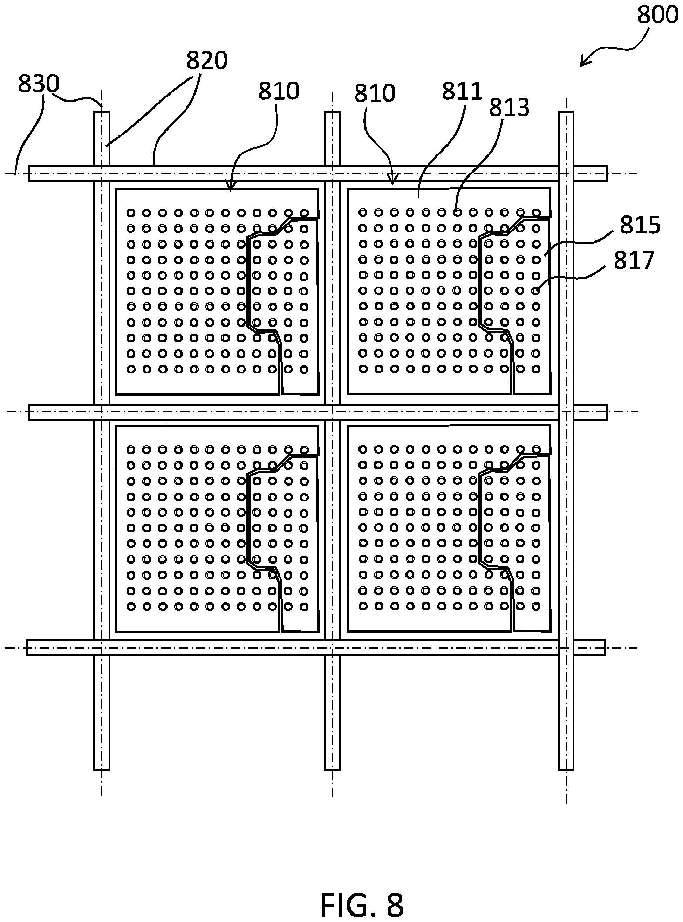

Fig. 8 illustrates a bonding surface 800 according to an embodiment. The joining surface 800 includes a plurality of chip regions 810. Each chip region 810 includes a ground metal region 811 and a transmission metal region 813. The wafer including the bonding face 800 is cut by dicing at the boundary of the chip region along boundary lines 830 defined in a lattice pattern on the bonding face 800. Boundary lines 830, indicated by dashed lines in Fig. 8, are geometrically defined on the wafer and need not necessarily be physically prepared on the surface of the wafer. The bonding surface 800 illustrated in Fig. 8 includes a cut metal region 820 that includes a boundary line 830. Accordingly, the wafer is cut in this cut metal region 820 and divided into a plurality of chip regions 810. The cut metal region 820 may or may not be connected to ground.

### < Embodiment 6: Configuration of Bonding Surface 5 >

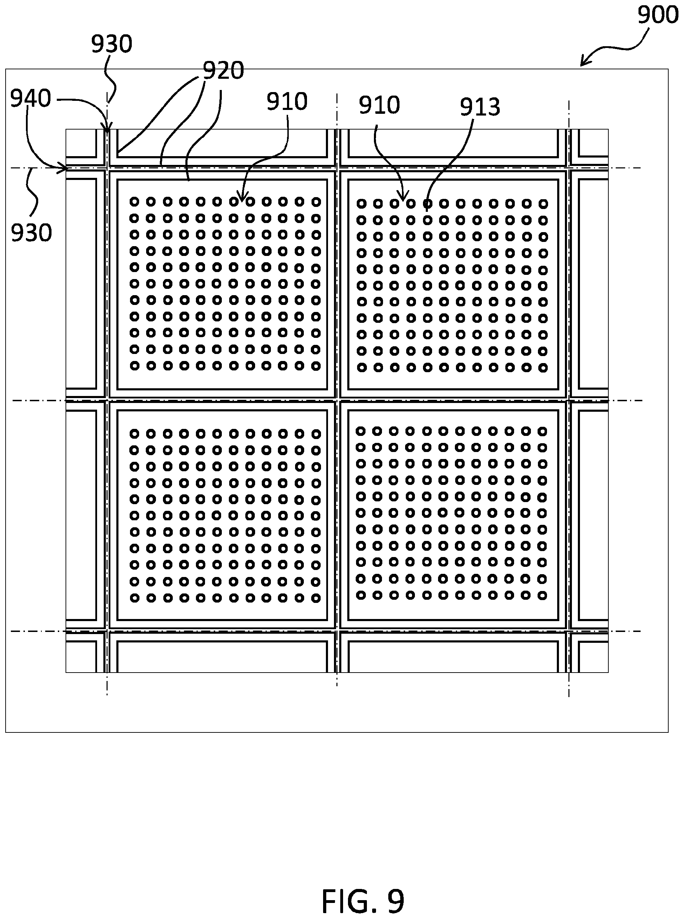

Fig. 9 illustrates a bonding surface 900 according to an embodiment. The joining surface 900 includes a plurality of chip regions 910. Each chip region 910 includes a transmission metal region 912. The wafer including the bonding face 900 is cut by dicing at the boundary of the chip region along boundary lines 930 defined in a lattice pattern on the bonding face 900. The bonding surface 900 shown in Fig. 9 includes a peripheral metal region 930 formed along a boundary line 930 and a non-metal region 940 formed through a center of the bonding metal region 930 to include the boundary line 930. A line of demarcation 930 is defined within or along this non-metal 940. Alternatively, the line of demarcation 930 is defined along the non-metal part 940. Accordingly, the wafer is cut along the non-metals 940 of this peripheral metal region 920 and divided into a plurality of chip regions 910. In Fig. 9, the peripheral metal region 920 is connected to ground and functions as a ground metal region.

The cut metal region 820 and the peripheral metal region 920 are not limited to the aspects illustrated in FIGS. 8 and 9, and may or may not be connected to ground, for example. When a wafer having such a bonding surface 800,900 is bonded to a substrate, such as another wafer, the cut metal region 820 and the peripheral metal region 920 also contribute to the bonding. In this way, for example and without limitation, bonding strength can be improved and/or signal transmission characteristics can be improved.

All or some features of the examples shown in FIGS. 6-9 are not limited to the illustrated examples, and may be used in combination with each other or incorporated into other embodiments unless consistent.

### < 2. Bonding Method >

First, a bonding method according to an embodiment will be described. At least a pair of substrates is provided. In some embodiments, both of the pair of substrates comprise a ground metal region (or a power supply metal region) and a signal transmission metal region. A corresponding metal region is then contacted with a corresponding region of another substrate. Electrical connections are formed between predetermined metal regions.

In other embodiments, one substrate may not necessarily comprise metal regions corresponding to all metal regions of the other substrate. For example, at least one substrate may comprise a ground metal region (or a power supply metal region) and a signal transmission metal region, and the other substrate may comprise at least one of them. One substrate may not necessarily comprise metal regions corresponding to all metal regions of the other substrate. The two substrates are bonded so as to allow the required signal transmission between the two connected substrates.

The surface of the metal region can be activated prior to contacting the substrate. As a result, for example, the bonding strength can be improved. Alternatively, sufficient strength can be obtained at low temperatures. Furthermore, even when heating is performed after the contact, the thermal energy thereof can be suppressed.

### < Room Temperature Bonding Method by Surface Activation >

The surface activation treatment may include irradiating a surface such as a metal region, a metal such as a metal material (usually covered with oxide under the atmosphere), a non-metal region, an insulating material, or the like with energy or energy particles.

The energetic particles may be generated using a particle beam source, such as an ion beam source or a fast atom beam (FAB) source, to accelerate ions or neutral atoms of the gas particles or atoms used or a mixture thereof. The irradiation of energy particles may be performed using a plasma source.

In some embodiments, a particle beam source can be used to impart predetermined kinetic energy to the particles. The particle beam source operates in a vacuum, such as, for example, a pressure of 1 × 10-5Pa (Pascals) or less. Material removed from the surface of the metal region is efficiently evacuated to the outside of the atmosphere by activation of the vacuum pump in order to draw a relatively high vacuum. This can inhibit the adherence of undesirable substances to the exposed nascent surface. Furthermore, because the particle beam source can apply a relatively high acceleration voltage, high kinetic energy can be imparted to the particles. Therefore, it is conceived that the removal of the surface layer and the activation of the new surface can be efficiently performed.

A fast atom beam source (FAB, Fast Atom Beam) can be used as the neutral atom beam source. The high-velocity atom beam source (FAB) is typically configured to generate a gas plasma, apply an electric field to this plasma, extract cations of the ionized particles from the plasma, and neutralize the cations by passing them through an electron cloud. In this case, for example, when argon (Ar) is used as the noble gas, the power supply to the fast atom beam source (FAB) may be set to 1.5 kV (kilovolts), 15 mA (milliamperes), or may be set to a value between 0.1 and 500 W (watts). For example, when the high-velocity atomic beam source (FAB) is operated at 100 W (Watt) to 200 W (Watt) and irradiated with a high-velocity atomic beam of argon (Ar) for about two minutes, the oxides, contaminants, etc. (surface layer) of the surfaces to be bonded can be removed, exposing the neovascular surface.

A cold cathode type ion source can be used as the ion beam source.

The energy particles may be or include noble gases. The noble gas may be argon or other noble gases. The energy particles may be neutral atoms or ions, may be radical species, or may be a group of particles in which these are mixed.

In some embodiments, the surface activation treatment may include irradiating with electromagnetic waves such as ultraviolet rays, lasers, or the like.

The term "surface activation" means a treatment or process that is performed on a surface that is not substantially bonded or joined when brought into contact without such contact, and a desired or substantially effective bond is obtained when the surfaces after the treatment or the like are brought into contact with each other. The stacked body formed by bonding the substrate after the surface activation treatment may or may not be subjected to heating, light treatment, or the like as is.

The rate of removal of the surface layer can vary depending on the operating conditions of each plasma or beam source, the kinetic energy of the particles, or the irradiation with electromagnetic waves. Therefore, it is necessary to adjust each condition including the treatment time of the surface activation treatment. For example, using a surface analysis method such as Auger electron spectroscopy (AES, Auger Electron Spectroscopy) or X ray photoelectron spectroscopy (XPS, X-ray Photo Electron Spectroscopy), The treatment time of the surface activation treatment may be a time in which the presence of oxygen or carbon contained in the surface layer cannot be confirmed or a longer time.

Surface activation may refer to a process or step performed after thin film formation or on a substrate in some embodiments, and may not be the case in some embodiments. In some embodiments, surface activation means or may include maintaining a bonding surface of a thin film active from the formation of the thin film. For example, surface activation may include forming a thin film in a vacuum and bonding the substrates without breaking the vacuum. Active surfaces may be formed in a vacuum and the substrates may be attached while still active.

The surface on which the thin film material is to be formed may be subjected to surface activation prior to thin film formation. In this way, illustratively, bonding strength between the substrate and the thin film can be increased.

Bonding or affixing the substrates may include bringing the bonding surfaces of the substrates into contact with each other. In some embodiments, bonding or laminating the substrates may include bringing bonding surfaces of the surface activated substrates into contact with each other.

In some embodiments, a force or pressure may be applied to the substrate from a side opposite or other than the bonding side of the substrate during the contacting. By applying pressure, for example, the degree of adhesion at the bonding interface can be increased.

In some embodiments, a force or pressure may be applied to the bonding surface or interface. For example, a force in a direction normal to the bonding surface may be applied from outside the substrate. In some embodiments, the substrate may be pressed or crimped during substrate bonding. In some embodiments, the application of pressure may apply a force such that it is substantially uniform across the contacted interface. In some embodiments, the pressurization may be performed at respective times for different ones of the contacted interface surfaces. The strength of the force during pressurization may be constant in time or may be variable. The pressurization may be performed at different timings for each part of the bonding surface. The joining surfaces may be sequentially pressurized by sliding and moving the pressurizing device with respect to the substrate in contact. The pressurizing device may have a roll-like pressurizing unit.

A method of bonding substrates included in the present disclosure includes: forming an oxide layer of a metal on a bonding surface of the substrate, from surface activation to the bonding surface or to a thin film on the bonding surface, to contacting the substrate; Contacting or laminating the pair of substrates may be performed consistently in a vacuum or in an atmosphere under low pressure, or may be performed without breaking the vacuum or low pressure atmosphere. An atmosphere in a vacuum or under low pressure may be an atmosphere having an atmospheric pressure of 10-16Pa or less. Alternatively, during that time, the substrate may be temporarily removed from the vacuum after surface activation, but at that time, a dummy substrate may be temporarily bonded to the bonding surface to avoid exposing the bonding surface to the atmosphere, and after being returned to the vacuum again, the dummy substrate may be removed to bring the bonding surfaces into contact with each other in the vacuum. An atmosphere in a vacuum or under low pressure may include this. By performing these steps in a vacuum, it is possible to avoid the attachment and adsorption of unnecessary substances to the bonding surface or the oxidation and/or hydroxide of the bonding surface, to efficiently activate the surface, to minimize or minimize the maintenance of the activity of the activated surface, and to avoid or reduce the occurrence of portions that are not bonded.

In some embodiments, the bonded substrates (also referred to as bonds, substrate stacks, etc. in the present disclosure) may be subjected to a thermal treatment. In some embodiments, the bonded body may be subjected to a thermal treatment. In some embodiments, the entire bond may be heated. In several embodiments, the reaction may be performed by irradiating the bonded body with light such as a laser or electromagnetic waves.

In some embodiments, the heat treatment may be conducted in an inert atmosphere. The inert atmosphere may be a vacuum, a nitrogen atmosphere, or an inert gas atmosphere such as argon, helium, or the like. Oxidation of the thin film material and the material inside the substrate due to heat treatment can be reduced or avoided. In some embodiments, the thermal treatment may be carried out in an active atmosphere. For example, heat treatment may be performed in ozone.

In some embodiments, the substrate may be pressurized or pressure-bonded during thermal treatment.

The bond strength of the joined body may be greater than or equal to 2 J/m2, 3 J/m2, 4 J/m2, etc. values. The bonding strength may be higher than the breaking strength of at least one of the pair of substrates.

In some embodiments, the surfaces of the metal regions may be activated and bonded, and the insulating surfaces may not be bonded. In some embodiments, the surfaces of the metal regions may be activated and bonded, and the insulating surfaces bonded. The surface of the insulating surface may also be activated.

### < Thermal bonding >

In some embodiments, no surface activation may occur. For example, the substrates may be brought into contact with each other and both substrates may be heated while in contact. By heating, oxides, impurities, and the like present on the surface of the metal region are removed, and the metal can come into direct contact with other metals to form a strong bond. The surface may be activated or heat may be applied after contacting or bonding.

### < Low Temperature Bond Method >

For example, as shown in Fig. 2, it may be in contact with an insulator or metal region of an insulator other substrate at the time of bonding. In some embodiments, an insulator may contact the metal region simultaneously. For example, as illustrated in Fig. 1, a substrate in which a metal region is formed protruding beyond an insulating surface may be used. Contact of some of the metal regions with other substrates does not form sufficient electrical and/or mechanical bonds. However, a portion of the insulator may be in contact with and bonded to another substrate. When the insulator has high surface activity, bonding of the insulator occurs first, and the bonding area thereof increases. As a result, pressure is applied to the surface of the protruding metal region, and the metal region is compressed. As a result, a strong bonding of the metal regions can be obtained. In some embodiments, the insulator may be contacted with the other substrate first, and substantially thereafter contacted or bonded by the metal region. In some embodiments, the insulator may be contacted with the other substrate first, and substantially thereafter contacted or bonded by the metal region.

The surface of the insulating surface may be, for example, a fluorinated oxide, a compound containing Si-O-F, or the like. The fluorination treatment may be performed by exposure to fluorine-containing liquids, vapors, gases, or by ion implantation. The surface may further be terminated with NH2 groups. The surface may, for example, expose the interface to a NH4OH solution. With these treatments, the insulating surface, such as the surface of the oxide, can obtain a high bonding force at a relatively low temperature (normal temperature or the like).

### < 3. Signal Transmission Characteristics >

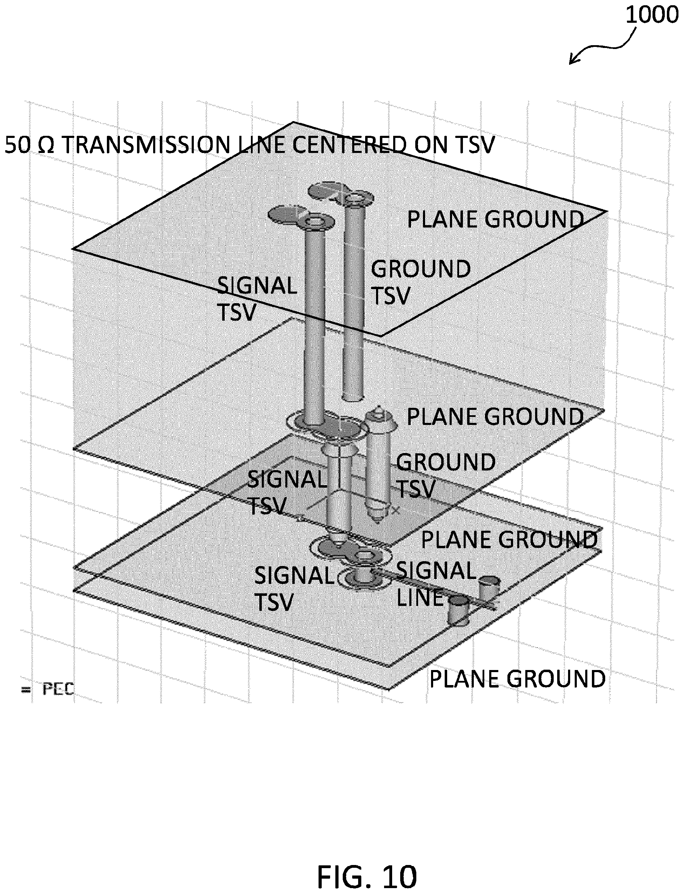

Fig. 10 illustrates the structure of the substrate joint body 1000 used in simulations. The substrate assembly 1000 is composed of three layers, and a plane ground (ground metal region) and a signal transmission pad are disposed on a top surface and a bottom surface of the layers. A ground TSV and a signal TSV are connected between the layers. The model is configured to have a transmission line of 50 ω.

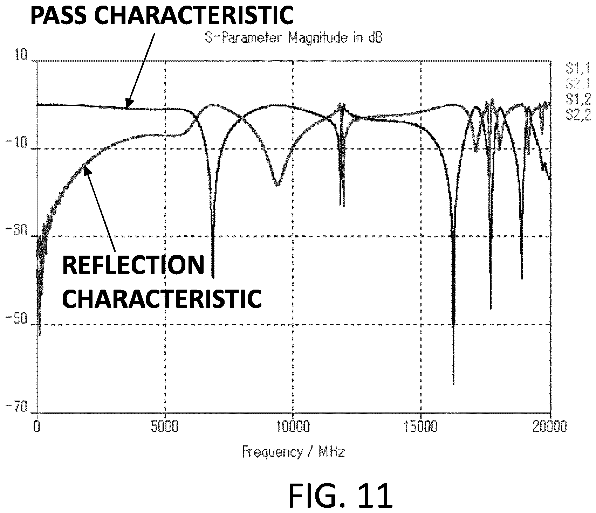

Fig. 11 illustrates signal pass characteristics and reflection characteristics carried out for the model illustrated in Fig. 10. The horizontal axis indicates signal frequency (megahertz, MHz), and the vertical axis indicates signal strength (decibels, dB). Resonances believed to be due to pad impedance mismatch are visible. In other words, by repeating reflection of the signal between the pads via the TSV, the pass characteristics are attenuated and the reflection characteristics are increased, thereby suddenly disturbing the frequency thereof. The frequency of the 1 order reflection depends on the length of each TSV. It is considered that the frequency of the secondary resonance mode is close to 20GHz. These resonances can be reduced. For example, the thickness of the substrate may be reduced, and the length of the TSV may be reduced. This makes it possible to shift the resonance frequency corresponding to the length of the TSV in a higher direction. From this result, excellent pass characteristics can be obtained up to high frequencies (for example, about 20GHz).

The present disclosure also provides the following embodiments: A001 a bonded structure, comprising: A001 a first substrate having a first bonding surface with a first signal transmission metal region and a first ground metal region insulated from the first signal transmission metal region; and a second substrate bonded to the first substrate, A second substrate; including a second bonding surface including a second signal transmission metal region and a second ground metal region insulated from the second signal transmission metal region, wherein the first signal transmission metal region and the second signal transmission metal region are bonded, and the first ground metal region and the second ground metal region are bonded. A002 The bonded structure of any of the above embodiments, wherein the first substrate comprises through electrodes penetrating the first substrate and connected to the first signal transmission metal region, and/or the second substrate comprises through electrodes penetrating the second substrate and connected to the second signal transmission metal region. A003 The bonded structure of any of the above embodiments, wherein the first substrate includes a through electrode that penetrates the first substrate and is connected to the first ground metal region, and/or the second substrate includes a through electrode that penetrates the second substrate and is connected to the second ground metal region. A004 The bonded structure of any of the above embodiments, wherein the first and/or second ground metal regions are connected to a ground or power supply. A005 The bonded structure of any of the above embodiments, wherein the first signal transmission metal face and/or the first signal transmission metal face is connected to an electronic element (e.g., a transistor), and the ground or the power source is a ground or power source of the electronic element (e.g., a transistor). A011 The bonded structure according to any of the above embodiments, wherein a total area of the first signal transmission metal region and the first ground metal region is greater than or equal to 10% of an area of the first bonding surface, and/or a total area of the second signal transmission metal region and the second ground metal region is greater than or equal to 10% of an area of the second bonding surface. A012 The bonded structure according to any of the above embodiments, wherein a total area of the first signal transmission metal region and the first ground metal region is greater than or equal to 30% of an area of the first bonding surface, and/or a total area of the second signal transmission metal region and the second ground metal region is greater than or equal to 30% of an area of the second bonding surface. A013 The bonded structure according to any of the above embodiments, wherein a total area of the first signal transmission metal region and the first ground metal region is greater than or equal to 60% of an area of the first bonding surface, and/or a total area of the second signal transmission metal region and the second ground metal region is greater than or equal to 60% of an area of the second bonding surface. A014 The bonded structure of any of the above embodiments, wherein an area of the first or second ground metal region is greater than an area of the first or second signal transmission metal region. A021 The bonded structure of any of the above embodiments, wherein the first or second signal transmission metal region is substantially surrounded by the first or second ground metal region within the first or second interface. A031 The bonded structure of any of the above embodiments, wherein the first or second signal transmission metal region is spaced apart from the first or second ground metal region within the first or second interface. A033 The bonded structure according to any of the above embodiments, wherein the first or second signal transmission metal region is spaced at least 0.1 µm apart from the first or second ground metal region in the first or second in-plane direction of the bond. A034 The bonded structure of any of the above embodiments, wherein the first or second bonding surface comprises an insulating surface at a spacing between the first or second signal transmission metal region and the first or second ground metal region. A035 The bonded structure according to any one of the above embodiments, wherein the first bonding surface includes a first insulating surface disposed between the first signal transmission metal region and the first ground metal region, and The second bonding surface includes a second insulating surface disposed between the second signal transmission metal region and the second ground metal region, and the first insulating surface and the second insulating surface are bonded to each other. A035b The bonded structure according to any one of the above embodiments, wherein the first bonding surface includes a first insulating surface disposed between the first signal transmission metal region and the first ground metal region, and The second bonding surface includes a second insulating surface disposed between the second signal transmission metal region and the second ground metal region, and the first insulating surface and the second insulating surface are not bonded to each other. A036 The bonded structure of any of the above embodiments, wherein the first or second signal transmission metal region and the first or second ground metal region are non-contact with respect to each other. A037 The bonded structure of any of the above embodiments, wherein the spacing between the first or second signal transmission metal region and the first or second ground metal region is formed of a gas or substantially vacuum. A041 The bonded structure of any of the above embodiments, wherein the first and/or second signal transmission metal regions comprise a plurality of first and/or second signal transmission metal regions. A042 The bonded structure of any of the preceding embodiments, wherein the plurality of first and/or second signal-transmission metal regions comprise at least one signal-transmission metal region for transmitting analog signals and at least one signal-transmission metal region for transmitting digital signals. A051 The bonded structure of any of the above embodiments, wherein the first and/or second ground metal regions comprise a plurality of first and/or second ground metal regions insulated from each other in a corresponding bonding plane. A052 The bonded structure of any of the above embodiments, wherein the plurality of first and/or second ground metal regions are connected to ground and/or to a different power source. A053 The bonded structure according to any one of the above embodiments, wherein a portion of the plurality of first and/or second ground metal regions is disposed within the corresponding bonded surface so as to surround the signal transmission metal region for analog signals, and Another portion of the plurality of first and/or second ground metal regions is disposed within the corresponding interface so as to surround the signal transmission metal region for digital signals. A061 The bonded structure of any of the above embodiments, wherein the ground metal region has a metal material disposed throughout or throughout the region. A062 The bonded structure of any of the above embodiments, wherein the ground metal region comprises a metal material disposed to cover a portion of the region in area. A063 The bonded structure of any of the above embodiments, wherein the ground metal region includes a metal-material-free portion in which no metal material is disposed. A064 The bonded structure of any of the above embodiments, wherein the metal-material-free portion is periodically disposed in whole or in part of the ground metal region. A065 The bonded structure of any of the above embodiments, wherein the metal material-free portion or the metal material is periodically disposed in whole or in part of a ground metal region periodically disposed within the ground metal region. A066 The bonded structure of any of the above embodiments, wherein the or the metal material is disposed in a mesh within the ground metal region. A067 The bonded structure of any of the above embodiments, wherein an area of the metal-material-free portion is from 10% to 50% of an area of the ground metal region. An A101 bonded structure comprising: a first substrate having a first bonding surface with a first signal transmission metal region and a first ground metal region insulated from the first signal transmission metal region; a second substrate bonded to the first substrate, A second upper joint surface having a second upper signal transmission metal region and a second upper ground metal region insulated from the second upper signal transmission metal region, the second upper j oint surface facing the first j oint surface, and a second lower joint surface having a second lower signal transmission metal region and a second lower ground metal region insulated from the second lower signal transmission metal region; And a third substrate bonded to the second substrate, the third substrate having a third signal transmission metal region and a third ground metal region insulated from the third signal transmission metal region, the third substrate having a third bonding surface opposite the second lower bonding surface; wherein the first signal transmission metal region and the second upper signal transmission metal region are bonded; Wherein the first ground metal region and the second upper ground metal region are bonded, the second lower signal transmission metal region and the third signal transmission metal region are bonded, and the second lower ground metal region and the third ground metal region are bonded. A102 The bonded structure of any of the above embodiments, comprising a plurality of substrates bonded to each other. A201 An electronic element comprising the bonded structure of any of the above embodiments. A202 An electronic circuit module comprising the bonded structure of any of the above embodiments. A203 An electronic device comprising the bonded structure of any of the above embodiments. A method of bonding an B001 substrate, comprising: providing a first substrate having a first bonding surface with a first signal transmission metal region and a first ground metal region insulated from the first signal transmission metal region; Providing a second substrate having a second interface with a second signal transmission metal region and a second ground metal region insulated from the second signal transmission metal region; contacting the first and second signal transmission metal regions; and contacting the first and second ground metal regions. B011 The method of any of the above embodiments, wherein contacting the first and second signal transmission metal regions comprises electrically connecting the first and second signal transmission metal regions, Wherein contacting the first and second ground metal regions comprises electrically coupling the first and second ground metal regions. B012 The method of any of the above embodiments, further comprising: activating a surface of at least one of the first and second signal transmission metal regions prior to contacting the first and second signal transmission metal regions and contacting the first and second ground metal regions; And activating a surface of at least one of the first and second ground metal regions, wherein contacting the first and second signal transmission metal regions comprises contacting the activated surface to the other; Wherein contacting the first and second ground metal regions comprises contacting the activated surface to the other. B013 The method according to any of the above embodiments, wherein the contacting comprises contacting in a vacuum. B014 The method of any of the above embodiments, wherein the activating comprises a process selected from the group consisting of plasma treatment, ion bombardment, atomic beam irradiation, radical irradiation, and electromagnetic wave irradiation. B015 The method of any of the above embodiments, wherein the contacting of the first and second signal transmission metal regions and the contacting of the first and second ground metal regions occurs without heating or at ambient temperature. B016 The method of any of the above embodiments, further comprising heating the first substrate and the second substrate after contacting the first and second signal transmission metal regions; and contacting the first and second ground metal regions.

As used herein, terms or expressions describing positional relationships such as "upper substrate", "intermediate substrate", "lower substrate", "second layer from top", "upper surface", "lower surface", "upper surface", "lower surface", and the like include: It is not necessarily to be construed as being defined with respect to a vertical direction, a gravitational direction, or a particular orientation of the device, but is used by way of example or in describing the drawings. For example, the "top substrate," intermediate substrate, "and" bottom substrate "may be respectively referred to as" first substrate, "second substrate," and "third substrate" (order is arbitrary); "Top surface" and "bottom surface" may be described as "first substrate" and "second substrate", respectively (in any order), or may be described using any number, adjectives, other nouns, or a set thereof, as appropriate.

While several embodiments and examples of the present disclosure have been described above, these embodiments and examples exemplarily describe the present disclosure. For example, the embodiments described above have been described in detail in order to clearly illustrate the disclosure, and dimensions, configurations, materials, and circuits may be additionally modified as necessary. Note that embodiments in which one or more of the features of the present disclosure described above are optionally combined are also included within the scope of the present disclosure. The claims cover numerous modifications to the embodiments without departing from the technical ideas of the present disclosure. Accordingly, the embodiments and examples disclosed herein are shown for purposes of illustration and should not be construed as limiting the scope of the present disclosure.

## Claims

1. A bonded structure, comprising: a first substrate having a first bonding surface with a first signal transmission metal region and a first ground metal region insulated from the first signal transmission metal region; and a second substrate bonded to the first substrate, A second substrate; including a second bonding surface including a second signal transmission metal region and a second ground metal region insulated from the second signal transmission metal region, wherein the first signal transmission metal region and the second signal transmission metal region are bonded, and the first ground metal region and the second ground metal region are bonded.

2. The bonded structure of Claim 1, wherein the first substrate comprises a through electrode penetrating the first substrate and connected to the first signal transmission metal region, and/or the second substrate comprises a through electrode penetrating the second substrate and connected to the second signal transmission metal region.

3. The bonded structure according to Claim 1 or 2, wherein the first substrate includes a through electrode that penetrates the first substrate and is connected to the first ground metal region, and/or the second substrate includes a through electrode that penetrates the second substrate and is connected to the second ground metal region.

4. The bonded structure according to any one of claims 1 to 3, wherein a total area of the first signal transmission metal region and the first ground metal region is greater than or equal to 10% of an area of the first bonding face, and/or a total area of the second signal transmission metal region and the second ground metal region is greater than or equal to 10% of an area of the second bonding face.

5. The bonded structure according to any one of claims 1 to 4, wherein a total area of the first signal transmission metal region and the first ground metal region is greater than or equal to 30% of an area of the first bonding face, and/or a total area of the second signal transmission metal region and the second ground metal region is greater than or equal to 30% of an area of the second bonding face.

6. The bonded structure according to any one of claims 1 to 5, wherein a total area of the first signal transmission metal region and the first ground metal region is greater than or equal to 60% of an area of the first bonding face, and/or a total area of the second signal transmission metal region and the second ground metal region is greater than or equal to 60% of an area of the second bonding face.

7. The bonded structure according to any one of Claims 1 to 6, wherein an area of the first or second ground metal region is greater than an area of the first or second signal transmission metal region.

8. The bonded structure of any one of Claims 1 to 7, wherein the first or second signal transmission metal region is substantially surrounded by the first or second ground metal region within the first or second interface surfaces.

9. The bonded structure according to any one of Claims 1 to 8, wherein the first or second signal transmission metal region is spaced apart from the first or second ground metal region within the first or second interface.

10. The bonded structure according to Claim 9, wherein the first or second bonding surface comprises an insulating surface at a spacing between the first or second signal transmission metal region and the first or second ground metal region.

11. The bonded structure according to claim 9 or 10, wherein: the first bonding surface includes a first insulating surface disposed between the first signal transmission metal region and the first ground metal region; andthe second bonding surface includes: A second insulating surface disposed between the second signal transmission metal region and the second ground metal region, wherein the first insulating surface and the second insulating surface are bonded to each other.

12. The bonded structure according to claim 9 or 10, wherein: the first bonding surface includes a first insulating surface disposed between the first signal transmission metal region and the first ground metal region; andthe second bonding surface includes: A second insulating surface disposed between the second signal transmission metal region and the second ground metal region, wherein the first insulating surface and the second insulating surface are not bonded to each other.

13. The bonded structure of any of claims 1 to 12, wherein the first and/or second signal transmission metal regions comprise a plurality of first and/or second signal transmission metal regions.

14. The bonded structure of Claim 13, wherein the plurality of first and/or second signal-transmission metal regions comprises at least one signal-transmission metal region for transmitting analog signals and at least one signal-transmission metal region for transmitting digital signals.

15. The bonded structure according to claim 13 or 14, wherein the first and/or second ground metal regions comprise a plurality of first and/or second ground metal regions insulated from each other in corresponding bonding planes.

16. The bonded structure of Claim 15, wherein the plurality of first and/or second ground metal regions are connected to a ground and/or a different power source.

17. The bonded structure according to any one of claims 14 to 16, whereina portion of the plurality of first and/or second ground metal regions is disposed so as to surround the signal transmission metal region for analog signals within the corresponding bonded surface; Another portion of the plurality of first and/or second ground metal regions is disposed within the corresponding interface so as to surround the signal transmission metal region for digital signals.

18. The bonded structure of any one of Claims 1 to 17, wherein the ground metal region has a metal material disposed in its entirety or solid.

19. The bonded structure of any one of Claims 1 to 17, wherein the ground metal region has a metal material-free portion.

20. A bonded structure, comprising: a first substrate having a first bonding surface with a first signal transmission metal region and a first ground metal region insulated from the first signal transmission metal region; a second substrate bonded to the first substrate, A second upper joint surface having a second upper signal transmission metal region and a second upper ground metal region insulated from the second upper signal transmission metal region, the second upper joint surface facing the first joint surface, and a second lower joint surface having a second lower signal transmission metal region and a second lower ground metal region insulated from the second lower signal transmission metal region; And a third substrate bonded to the second substrate, the third substrate having a third signal transmission metal region and a third ground metal region insulated from the third signal transmission metal region, the third substrate having a third bonding surface opposite the second lower bonding surface; wherein the first signal transmission metal region and the second upper signal transmission metal region are bonded; Wherein the first ground metal region and the second upper ground metal region are bonded, the second lower signal transmission metal region and the third signal transmission metal region are bonded, and the second lower ground metal region and the third ground metal region are bonded.

21. The bonded structure according to any one of Claims 1 to 20, comprising a plurality of substrates bonded to each other.

22. An electronic element, an electronic circuit module, or an electronic apparatus comprising the bonded structure described in any one of claims 1 to 21.

23. A method of bonding substrates, comprising: providing a first substrate having a first bonding surface with a first signal transmission metal region and a first ground metal region insulated from the first signal transmission metal region; Providing a second substrate having a second interface with a second signal transmission metal region and a second ground metal region insulated from the second signal transmission metal region; contacting the first and second signal transmission metal regions; and contacting the first and second ground metal regions.

24. The method of claim 23, wherein contacting the first and second signal transmission metal regions comprises electrically connecting the first and second signal transmission metal regions, Wherein contacting the first and second ground metal regions comprises electrically coupling the first and second ground metal regions.

25. The method of claim 24, further comprising: activating a surface of at least one of the first and second signal transmission metal regions prior to contacting the first and second signal transmission metal regions and contacting the first and second ground metal regions; And activating a surface of at least one of the first and second ground metal regions, wherein contacting the first and second signal transmission metal regions comprises contacting the activated surface to the other; Wherein contacting the first and second ground metal regions comprises contacting the activated surface to the other.

26. The method of claim 25, wherein the contacting comprises contacting in a vacuum.

27. The method according to claim 25 or 26, wherein the activating comprises a process selected from the group consisting of plasma treatment, ion bombardment, atomic beam irradiation, radical irradiation, and electromagnetic wave irradiation.

28. The method of any one of claims 25 to 27, wherein contacting the first signal transmission metal region and the second signal transmission metal region and contacting the first ground metal region and the second ground metal region are performed without heating or at ambient temperature.

29. The method of any one of claims 23 to 28, further comprising heating the first substrate and the second substrate after contacting the first and second signal transmission metal regions; and contacting the first and second ground metal regions.

## Amended claims

### Amended claims under Art. 19.1 PCT

1. [Amended] a bonded structure, comprising: a first substrate having a first bonding surface with a first signal transmission metal region and a first ground metal region insulated from the first signal transmission metal region; And a second substrate bonded to the first substrate, the second substrate having a second bonding surface with a second signal transmission metal region and a second ground metal region insulated from the second signal transmission metal region; The first signal transmission metal region and the second signal transmission metal region are bonded, the first ground metal region and the second ground metal region are bonded, and the first or second signal transmission metal region includes: The first or second ground metal region is substantially surrounded by the first or second ground metal region within the first or second interface, and the first or second ground metal region includes a metal material disposed entirely or entirely within the region.

2. The bonded structure of Claim 1, wherein the first substrate comprises a through electrode penetrating the first substrate and connected to the first signal transmission metal region, and/or the second substrate comprises a through electrode penetrating the second substrate and connected to the second signal transmission metal region.

3. The bonded structure according to Claim 1 or 2, wherein the first substrate includes a through electrode that penetrates the first substrate and is connected to the first ground metal region, and/or the second substrate includes a through electrode that penetrates the second substrate and is connected to the second ground metal region.

4. The bonded structure according to any one of claims 1 to 3, wherein a total area of the first signal transmission metal region and the first ground metal region is greater than or equal to 10% of an area of the first bonding face, and/or a total area of the second signal transmission metal region and the second ground metal region is greater than or equal to 10% of an area of the second bonding face.

5. The bonded structure according to any one of claims 1 to 4, wherein a total area of the first signal transmission metal region and the first ground metal region is greater than or equal to 30% of an area of the first bonding face, and/or a total area of the second signal transmission metal region and the second ground metal region is greater than or equal to 30% of an area of the second bonding face.

6. The bonded structure according to any one of claims 1 to 5, wherein a total area of the first signal transmission metal region and the first ground metal region is greater than or equal to 60% of an area of the first bonding face, and/or a total area of the second signal transmission metal region and the second ground metal region is greater than or equal to 60% of an area of the second bonding face.

7. The bonded structure according to any one of Claims 1 to 6, wherein an area of the first or second ground metal region is greater than an area of the first or second signal transmission metal region.

8. [Deleted]

9. [Amended] The bonded structure of any one of Claims 1 to 7, wherein the first or second signal transmission metal region is spaced apart from the first or second ground metal region within the first or second interface.

10. The bonded structure according to Claim 9, wherein the first or second bonding surface comprises an insulating surface at a spacing between the first or second signal transmission metal region and the first or second ground metal region.

11. The bonded structure according to claim 9 or 10, wherein: the first bonding surface includes a first insulating surface disposed between the first signal transmission metal region and the first ground metal region; andthe second bonding surface includes: A second insulating surface disposed between the second signal transmission metal region and the second ground metal region, wherein the first insulating surface and the second insulating surface are bonded to each other.

12. The bonded structure according to claim 9 or 10, wherein: the first bonding surface includes a first insulating surface disposed between the first signal transmission metal region and the first ground metal region; andthe second bonding surface includes: A second insulating surface disposed between the second signal transmission metal region and the second ground metal region, wherein the first insulating surface and the second insulating surface are not bonded to each other.

13. The bonded structure of any of claims 1 to 12, wherein the first and/or second signal transmission metal regions comprise a plurality of first and/or second signal transmission metal regions.

14. The bonded structure of Claim 13, wherein the plurality of first and/or second signal-transmission metal regions comprises at least one signal-transmission metal region for transmitting analog signals and at least one signal-transmission metal region for transmitting digital signals.

15. The bonded structure according to claim 13 or 14, wherein the first and/or second ground metal regions comprise a plurality of first and/or second ground metal regions insulated from each other in corresponding bonding planes.

16. The bonded structure of Claim 15, wherein the plurality of first and/or second ground metal regions are connected to a ground and/or a different power source.

17. The bonded structure according to any one of claims 14 to 16, whereina portion of the plurality of first and/or second ground metal regions is disposed so as to surround the signal transmission metal region for analog signals within the corresponding bonded surface; Another portion of the plurality of first and/or second ground metal regions is disposed within the corresponding interface so as to surround the signal transmission metal region for digital signals.

18. [Deleted]

19. [Amended] The bonded structure of any one of Claims 1 to 17, wherein the ground metal region includes a metal material-free portion.

20. [Amended] a bonded structure, comprising: a first substrate having a first bonding surface with a first signal transmission metal region and a first ground metal region insulated from the first signal transmission metal region; A second substrate joined to the first substrate, the second substrate having a second upper signal transmission metal region and a second upper ground metal region insulated from the second upper signal transmission metal region, the second upper joining surface facing the first joining surface; A second lower bonding surface having a second lower signal transmission metal region and a second lower ground metal region insulated from the second lower signal transmission metal region; and a third substrate bonded to the second substrate, A third substrate; having a third signal transmission metal region and a third ground metal region insulated from the third signal transmission metal region, and having a third joining surface opposite the second lower joining surface, The first signal transmission metal region and the second upper signal transmission metal region are joined, the first ground metal region and the second upper ground metal region are joined, the second lower signal transmission metal region and the third signal transmission metal region are joined, and Wherein the second lower ground metal region and the third ground metal region are joined, and the first or second upper signal transmission metal region is formed within the first or second upper joint surface by: Substantially surrounded by the first or second upper ground metal region, the first or second upper ground metal region including a metal material disposed entirely or entirely within the region, and the second lower or third signal transmission metal region including: Substantially surrounded by the second bottom or third ground metal region within the second bottom or third interface surface, and the second bottom or third ground metal region includes metal material disposed entirely or entirely within the region.

21. The bonded structure according to any one of Claims 1 to 20, comprising a plurality of substrates bonded to each other.

22. An electronic element, an electronic circuit module, or an electronic apparatus comprising the bonded structure described in any one of claims 1 to 21.

23. [Amended] a method of bonding substrates, comprising: providing a first substrate having a first bonding surface with a first signal transmission metal region and a first ground metal region insulated from the first signal transmission metal region; Providing a second substrate bonded to the first substrate, the second substrate having a second bonding surface with a second signal transmission metal region and a second ground metal region insulated from the second signal transmission metal region; Contacting the first and second signal transmission metal regions; and contacting the first and second ground metal regions, wherein the first or second signal transmission metal regions comprise: Substantially surrounded by the first or second ground metal region within the first or second interface, and the first or second ground metal region includes metal material disposed entirely or entirely within the region.

24. The method of claim 23, wherein contacting the first and second signal transmission metal regions comprises electrically connecting the first and second signal transmission metal regions, Wherein contacting the first and second ground metal regions comprises electrically coupling the first and second ground metal regions.

25. The method of claim 24, further comprising: activating a surface of at least one of the first and second signal transmission metal regions prior to contacting the first and second signal transmission metal regions and contacting the first and second ground metal regions; And activating a surface of at least one of the first and second ground metal regions, wherein contacting the first and second signal transmission metal regions comprises contacting the activated surface to the other; Wherein contacting the first and second ground metal regions comprises contacting the activated surface to the other.

26. The method of claim 25, wherein the contacting comprises contacting in a vacuum.

27. The method according to claim 25 or 26, wherein the activating comprises a process selected from the group consisting of plasma treatment, ion bombardment, atomic beam irradiation, radical irradiation, and electromagnetic wave irradiation.

28. The method of any one of claims 25 to 27, wherein contacting the first signal transmission metal region and the second signal transmission metal region and contacting the first ground metal region and the second ground metal region are performed without heating or at ambient temperature.

29. The method of any one of claims 23 to 28, further comprising heating the first substrate and the second substrate after contacting the first and second signal transmission metal regions; and contacting the first and second ground metal regions.

## Amended claims

### Amended claims under Art. 19.1 PCT

Applicant has incorporated into claims 1, 20, and 23 prior to amendment claims 8 and 18 or descriptions substantially equivalent thereto. Accordingly, claims 8 and 18 have been deleted and the claim numbering has been changed formally.
